# EUROPEAN PATENT APPLICATION

(11) **EP 3 428 309 A1**
(43) Date of publication of application: **16.01.2019**
(21) Application number: 17763230.4
(22) Date of filing: 07.03.2017
(51) Int. Cl.: C23C 14/34, B22D 1/00, B22D 21/00, C22C 9/00, C22C 9/01, C22C 9/05, H01L 21/28, H01L 21/285

(54) **COPPER OR COPPER ALLOY TARGET CONTAINING ARGON OR HYDROGEN**

(30) Priority: 09.03.2016 JP 2016045611
(71) Applicant: JX Nippon Mining & Metals Corporation, Tokyo 100-8164 (JP)
(72) Inventor: OTSUKI Tomio, Kitaibaraki-shi Ibaraki 319-1535 (JP); NAGATA Kenichi, Kitaibaraki-shi Ibaraki 319-1535 (JP); MORII Yasushi, Kitaibaraki-shi Ibaraki 319-1535 (JP)
(74) Representative: Cornford, James Robert
(86) International application number: PCT/JP2017/008965
(87) International publication number: WO 2017/154890

(57) **Abstract**

Provided is a sputtering target formed from copper or a copper alloy, and the sputtering target contains either argon or hydrogen, or both, each in an amount of 1 wtppm or more and 10 wtppm or less. An object of the embodiment of the present invention is to provide a copper or copper alloy sputtering target which is capable of stably maintaining discharge even under conditions such as low pressure and low gas flow rate where it is difficult to continuously maintain sputtering discharge.

## Description

### TECHNICAL FIELD

Embodiments of the present invention relates to a copper or copper alloy sputtering target for use in forming wires of a semiconductor device, and in particular relates to a copper or copper alloy sputtering target capable of maintaining a stable discharge while meeting the needs of lower pressures in the process, as well as to the production method thereof.

### BACKGROUND ART

Conventionally, aluminum (Al) has often been used as the wire material of semiconductor devices, but with wires for use in large scale integrated circuits (LSI) in which the operation speed of the microprocessor (MPU) is emphasized, the thinning of circuit wires is being sought in addition to the miniaturization associated with the increase in the integration of elements, and the continued use of conventional Al wires caused new problems in that the wiring resistance would increase, which in turn would increase signal delays and power loss. A signal delay of elements obstructs the speed-up of the operation speed of the MPU, and power loss increases the power consumption and heat generation of the semiconductor device to an unignorable level.

In order to deal with the foregoing new problems associated with the miniaturization of elements in the LSI, the technology of replacing the conventionally used wire material of Al with copper (Cu) has been considered. While the resistivity of Al is approximately 2.7 × 10⁻⁶ Ωcm, the resistivity of Cu is low at approximately 1.7 × 10⁻⁶ Ωcm, and Cu has been a promising wire material from the past because Cu is able to resolve the problems arising from high resistivity, and also because Cu yields high electro migration resistance. Nevertheless, because Cu has a large diffusion coefficient, Cu atoms become diffused during the process and penetrate areas other than the wiring portion, and Cu is also a material that is difficult to process via reactive ion etching.

Incidentally, the wire patterning via etching was no longer required as a result of adopting a new method (damascene process) of forming, as the base material of the Cu wire, a diffusion barrier layer formed from a material made of tantalum (Ta) or tantalum nitride (TaN) having a function of preventing the diffusion of Cu to deal with the problem of diffusion, and further forming a groove at the wiring portion in advance via lithography, pouring Cu so as to fill the groove, and then flattening the surface via chemical mechanical polishing (CMP). As a result of this kind of technological innovation, Cu wires are now being generally used in the LSI of an MPU and the like.

When preparing Cu wires based on the foregoing process, a diffusion barrier layer is formed, via sputtering or other processes, on a groove formed in the interlayer insulating film, and Cu is poured therein. Here, the standard practice is to form a thin, uniform seed layer formed from Cu or a Cu alloy via sputtering in order to promote the formation of the Cu layer in the wiring portion. After forming the foregoing seed layer, a thick Cu wire layer is formed via sputtering based on conditions that enable a faster deposition rate, or a wet process such as the plating method. In order to obtain a Cu wire having uniform and favorable electrical conduction properties, the formation of a seed layer having favorable characteristics via sputtering is an important technical aspect.

Nevertheless, in recent years, even more severe conditions are being demanded even in the process upon forming wires. Patent Document 1 describes a problem where argon (Ar), which is used as the discharge gas during sputtering, becomes absorbed in the Cu layer upon forming the Cu seed layer via sputtering, and the Cu layer becomes a coarse, uneven layer. Patent Document 1 discloses a technique of igniting the plasma upon introducing Ar up to an easily dischargeable pressure upon commencing discharge for sputtering, and thereafter discontinuing the supply of Ar, or reducing the amount of supplied Ar to a sufficiently low level, and continuing the sputtering process. Accordingly, consideration has been given from the past from the perspective of controlling the process conditions in order to perform sputtering even under low pressure conditions. Nevertheless, Patent Document 1 fails to give sufficient consideration from the perspective of the properties of the sputtering target.

When performing discharge at a low pressure, the voltage applied to the sputtering target generally tends to increase, but as the voltage applied to the target is increased, the possibility of abnormal discharge such as arcing will consequently increase, the damage to the target caused by the abnormal discharge will increase, and these problems lead to adverse effects such as the increase in the number of particles. In order to deal with the foregoing problems, Patent Document 2 describes purifying the Cu sputtering target to the extent possible, and eliminating the amount of impurity elements as much as possible. While this kind of technique may be effective for pure copper, it cannot be substantially applied to a Cu alloy sputtering target which contains Al and other prescribed elements. Moreover, high purity anodes and electrolytes are required for the production of a sputtering target, and it cannot necessarily be said that the foregoing technology can be easily applied because a clean room of a specific class or higher is required, among other factors.

Meanwhile, there are techniques which stabilize the discharge during sputtering by initiatively introducing a predetermined amount of impurities into the sputtering target. Patent Document 3 discloses a technology related to a sputtering target capable of stably maintaining discharge over a long period by adding a predetermined amount of silver (Ag), gold (Au), copper (Cu) and other metal elements to a tantalum (Ta) sputtering target. Nevertheless, Patent Document 3 is related to Ta, and, in addition to the fact that there is no rationality in deeming that Patent Document 3 can also be simply applied to Cu, the inclusion of impurity elements other than the intended alloy elements is generally undesirable because it changes the resistance characteristics of the Cu layer.

Patent Documents 4 to 6 describe melting a copper alloy, which is a base material of the sputtering target, in an Ar atmosphere as an inert atmosphere upon casting the copper alloy. Nevertheless, Patent Documents 4 to 6 merely describe causing the atmosphere to be an Ar atmosphere upon casting the copper alloy, and do not in any way disclose the technical concept of initiatively introducing a prescribed amount of gas components into the target or describe the reason thereof, or offer any description of performing special technical operations such as blowing Ar gas at a specific flow rate onto the raw material molten metal surface. In addition, Patent Documents 4 to 6 do not in any way describe or even suggest the Ar content contained in the copper alloy after the casting process, or the relationship between the Ar content and the sputtering discharge stability, and also have no recognition regarding the technical problems or effects related thereto.

### CITATION LIST

### PATENT DOCUMENTS

Patent Document 1: JP 2001-226767 A
Patent Document 2: JP 2005-034337 A
Patent Document 3: JP 4825345 B
Patent Document 4: JP 2007-051351 A
Patent Document 5: JP 2004-193546 A
Patent Document 6: JP H10-060633 A

### SUMMARY OF THE INVENTION

### TECHNICAL PROBLEM

In this way, in recent copper wire processes, though there are demands to stably perform sputtering even at a low pressure, sufficient consideration was not given and sufficient examination was not conducted from the perspective of the properties of the sputtering target itself. Thus, an object of the embodiment of the present invention is to provide a copper or copper alloy sputtering target capable of stably maintaining discharge even under conditions such as low pressure and low gas flow rate where it is difficult to continuously maintain sputtering discharge, as well as to provide a method of easily producing such a sputtering target.

### SOLUTION TO PROBLEM

In order to solve the technical problem, as a result of intense study, the present inventors discovered that the addition of Ar or hydrogen (H) in an amount within a specific range to the Cu or Cu alloy base material to be a sputtering target is effective in stabilizing the discharge; and completed embodiments of the present invention after exhaustive consideration on the details of effective conditions.

Based on the above findings and results, the present inventors provides the following embodiment of the invention.
1) A sputtering target formed from copper or a copper alloy, and includes argon and/or hydrogen each in an amount of 1 wtppm or more and 10 wtppm or less.
2) The sputtering target according to 1) above, wherein the sputtering target contains only argon out of argon or hydrogen.
3) The sputtering target according to 1) above, wherein the sputtering target contains only hydrogen out of argon or hydrogen.
4) The sputtering target according to 1) above, wherein the sputtering target contains both argon and hydrogen.
5) The sputtering target according to any one of 1) to 4) above, wherein the sputtering target is formed from a copper alloy containing either aluminum or manganese.
6) The sputtering target according to any one of 1) to 5) above, wherein the copper alloy is a copper alloy which contains 0.1 to 5 wt% of aluminum, or 0.1 to 15 wt% of manganese.
7) A method of producing the sputtering target according to any one of 1) to 6) above, comprising: a step of preparing a copper or copper alloy raw material; a step of melting the raw material while blowing argon and/or hydrogen into the raw material; a step of cooling and solidifying the melted raw material into a copper or copper alloy ingot; and a step of processing the ingot into a sputtering target.

### EFFECTS OF INVENTION

According to the embodiment of the present invention, because the Ar or H atoms contained in the base material of the sputtering target are intermittently discharged onto the target surface during sputtering and contribute to the stable continuation of the sputtering discharge, sputtering deposition can be stably continued easily even under conditions such as low pressure and low gas flow rate where it is difficult to continuously maintain sputtering discharge. The Ar or H content of the sputtering target incorporated into the deposited Cu or Cu layer is such a low level that the inclusion thereof will not become a problem, and will be able to expand freedom in the design of the wire layer composition and process conditions. In addition, the sputtering target based on a relatively simple method will make it possible to improve the productivity of the sputtering target, which consequently can suppress the production cost of the final product.

### DESCRIPTION OF EMBODIMENTS

The sputtering target of the embodiment of the present invention is characterized in that its base material formed from pure Cu excluding unavoidable impurities, or a Cu alloy obtained by adding elements such as Al, Mn, Sn, Ti, and Zn to Cu in a predetermined composition ratio, contains argon and/or hydrogen each in an amount of 1 wtppm or more and 10 wtppm or less. It is considered that the atoms of Ar or H contained in the foregoing target base material are intermittently discharged from the target surface during sputtering, and cause a state where the density of the discharge gas is locally high near the target surface. Accordingly, even in a state where the discharge gas pressure in the deposition chamber is low other than near the target surface, gas components that contribute to discharge near the target surface where discharge is generated will exist in a relatively large amount, and, consequently, discharge can be continued in the overall deposition chamber even under low pressure conditions in which the continuation of discharge is difficult.

The amount of Ar or H in the sputtering target needs to be 1 wtppm or more for each of Ar or H that is contained. When the amount of Ar or H is less than 1 wtppm, the amount required for continuing the discharge will be insufficient, and there is a possibility that the plasma cannot be stably maintained. From the perspective of discharge duration, the amount of Ar or H in the sputtering target is preferably 1.5 wtppm or more, and may be 2 wtppm or more, for each of Ar or H that is contained. Nevertheless, if the amount of Ar or H in the sputtering target is excessive, the discharge may become unstable, abnormal discharge such as arcing may occur, and there may be adverse effects from the inclusion of Ar or H in the deposited Cu or Cu alloy layer. Thus, the upper limit of the Ar or H content is 10 wtppm. This upper limit of the Ar or H content is preferably 8 ppm or less, and more preferably 5 ppm or less.

In order to improve the discharge stability under low pressure, it is preferable to add Ar in which the electron-based ionization cross section is large and the ionization potential is small. Ar is relatively inexpensive among rare gases, and is an element with favorable characteristics that contribute to ionization as described above. Ar, which is once discharged from the target surface and becomes ionized, may once again reach the plasma sheath of the target surface, and contribute to the sputtering of the Cu or Cu alloy of the target material.

By adding H to the sputtering target in cases where oxygen is contained as an impurity in the sputtering target or the deposition atmosphere, it is possible to reduce the amount of oxygen that becomes included in the deposited Cu or Cu alloy layer, since H exhibits reduction. Whether Ar and/or H should be included in the sputtering target and the content thereof can be suitably selected and adjusted by giving consideration to the foregoing effects. In order to improve the discharge stability as well as reduce the amount of oxygen in the deposited Cu or Cu alloy layer, it would be preferable to include both Ar and H in the sputtering target.

When the base material of the sputtering target of the embodiment of the present invention is formed from a Cu alloy, the Cu alloy is preferably a Cu alloy which contains either Al or Mn. When Cu is used as the wire material of an LSI or the like, a diffusion barrier layer for preventing the diffusion of Cu is required as described above, but as a result of adding Mn to Cu, it is possible to cause Cu to self-form a diffusion barrier layer as a result of Mn reacting with the oxygen in the oxide insulation layer of the interlayer insulating film or the element separation film. Moreover, as a result of adding Al to Cu, it is possible to suppress electro migration in the Cu wire which is becoming notable due to the further refinement of the Cu wire. In order to sufficiently exhibit the foregoing effects, Mn or Al is contained in an amount of 0.1 at% or more, and preferably in an amount of 0.5 at% or more. However, if the additive amount of Mn or Al is excessive, the resistivity will deteriorate and the inherent technical advantage of the Cu wire may become lost. Thus, the upper limit of the content is preferably 5 at% for Al, and 15 at% for Mn.

The sputtering target of the embodiment of the present invention is not limited to a specific production method, and may be produced based on any kind of method so as long as the sputtering target is able to contain Ar and/or H each in an amount of 1 wtppm or more and 10 wtppm or less. In order to produce this kind of sputtering target having the foregoing Ar or H content, it would be effective to produce, as the Cu or Cu alloy ingot to become the target base material, a Cu or Cu alloy ingot containing Ar and/or H each in an amount of 1 wtppm or more and 10 wtppm or less. As an example of a method of producing this kind of ingot, considered may be a method of introducing Ar or H into the atmosphere upon producing the Cu or Cu alloy ingot via melting/casting.

A Cu or Cu alloy ingot to become the base material of the sputtering target is generally produced by melting/casting elementary Cu metal as the raw material, upon adding elementary metals as the alloy element source other than Cu as needed. Moreover, a material in which Cu and other metal elements have already been alloyed at the stage of the raw material may also be used. Argon gas or hydrogen (H₂) gas is blown onto the molten metal during the melting/casting process. As the gases to be used, preferably, high purity argon gas and high purity hydrogen gas are respectively used. The amount of Ar and/or H to be introduced into the cast ingot can be adjusted by controlling the atmospheric composition, pressure, flow rate and other factors during the casting process. The foregoing parameters are controlled and adjusted so that Ar or H can be contained in the ingot as the base material of the sputtering target.

In order to blow argon gas or hydrogen gas onto the molten metal during the melting/casting of the raw material, various methods that have been put into practical application as the copper melting/casting method may be used; for instance, the method of blowing these gases during the heating and melting of the raw material in a heating/melting furnace in which the atmosphere can be controlled, the method of blowing these gases in a holding furnace of the raw material molten metal after the heating and melting process, the method of circulating these gases in the atmosphere or blowing these gases on the molten metal surface during an electrical melting process such as high-frequency induction heating or electron beam melting, or the method of circulating these gases in the atmosphere or blowing these gases on the molten metal surface during the heating and melting process using a plasma torch or the like.

In this way, Cu or Cu alloy ingot containing the target amount of Ar or H is processed, as needed, into a sputtering target. Here, while it goes without saying that forging, rolling and other processing, as well as heat treatment, for controlling the microstructure may be performed in addition to processes such as cutting and surface polishing for adjusting the ingot to obtain the final shape, the content of Ar or H needs to be 1 wtppm or more and 10 wtppm or less at the time the sputtering target is obtained after undergoing the final process.

According to an embodiment of the present invention, the content of Ar in the Cu or Cu alloy base material refers to the analytical value based on quantitative analysis using an analyzer (TC-436 manufactured by LECO) based on the inert gas melting-thermal conductivity method, and the content of H refers to the analytical value based on quantitative analysis using an analyzer (CS-444 manufactured by LECO) based on the non-dispersive infrared absorption method.

### EXAMPLES

The embodiment of the present invention is described in detail based on the Examples and Comparative Examples. The following Examples and Comparative Examples are merely specific examples to facilitate the understanding of the technical aspects of the present invention, and the technical scope of the present invention shall not be limited by these specific examples.

### Example 1

High purity Cu having a purity of 6N was used as a raw material, and it was heated and melted to obtain a raw material molten metal. During the heating and melting of the raw material, H₂ gas was continuously blown at a flow rate of 0.7 scfm (19.81 slm) and Ar gas was continuously blown at a flow rate of 24 scfm (679.2 slm) from a gas blowing nozzle having a circular blowing port shape, in which the diameter thereof is 5 mm, toward a surface of the raw material molten metal upon setting a shortest distance between a tip of the blowing port and the molten metal surface to be 100 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content was 2 wtppm and the Ar content was 1.5 wtppm.

Further, an evaluation test of the discharge stability was performed to this sputtering target. The evaluation method in this test included the steps of mounting the target on a magnetron cathode of a sputtering device, evacuating the chamber up to a base vacuum degree (base pressure), thereafter introducing Ar at a flow rate of 4 sccm, and measuring the continuous duration of the plasma that was generated by applying a voltage of 38 kW to the target in this state. The evaluation time was set to 350 seconds at the maximum and the results are shown in Table 1. With the target of Example 1, the plasma was able to be continuously and stably maintained for a period of 350 seconds as the maximum evaluation time.

### Example 2

High purity Cu having a purity of 6N was used as a raw material, and it was heated and melted to obtain a raw material molten metal. During the heating and melting of the raw material, H₂ gas was continuously blown at a flow rate of 0.4 scfm (11.32 slm) and Ar gas was continuously blown at a flow rate of 14 scfm (396.2 slm) from a gas blowing nozzle having a rectangular blowing port shape, in which the long side thereof is 8 mm and the short side thereof is 3 mm, toward a surface of the raw material molten metal upon setting a shortest distance between a tip of the blowing port and the molten metal surface to be 120 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content was 1.2 wtppm and the Ar content was 1 wtppm. Further, in the evaluation test of the discharge stability performed in the same manner as Example 1 regarding this sputtering target, the continuous duration of the plasma was 320 seconds.

### Example 3

High purity Cu having a purity of 6N was used as a raw material, and it was heated and melted to obtain a raw material molten metal. During the heating and melting of the raw material, H₂ gas was continuously blown at a flow rate of 0 scfm (0 slm) and Ar gas was continuously blown at a flow rate of 8 scfm (226.4 slm) from a gas blowing nozzle having an oval blowing port shape, in which the major axis thereof is 10 mm and the minor axis thereof is 4 mm, toward a surface of the raw material molten metal upon setting a shortest distance between a tip of the blowing port and the molten metal surface to be 90 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content was less than 1 wtppm, which is below the detection limit, and the Ar content was 1.2 wtppm. Further, in the evaluation test of the discharge stability performed in the same manner as Example 1 regarding this sputtering target, the continuous duration of the plasma was 314 seconds.

### Example 4

High purity Cu having a purity of 6N was used as a raw material, and it was heated and melted to obtain a raw material molten metal. During the heating and melting of the raw material, H2 gas was continuously blown at a flow rate of 0.5 scfm (14.15 slm) and Ar gas was continuously blown at a flow rate of 0 scfm (0 slm) from a gas blowing nozzle having an isosceles triangle blowing port shape, in which the base thereof is 10 mm and the height thereof is 10 mm, toward a surface of the raw material molten metal upon setting a shortest distance between a tip of the blowing port and the molten metal surface to be 110 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content was 1.2 wtppm and the Ar content was less than 1 wtppm, which is below the detection limit. Further, in the evaluation test of the discharge stability performed in the same manner as Example 1 regarding this sputtering target, the continuous duration of the plasma was 307 seconds.

### Example 5

0.1 wt% of high purity Al having a purity of 5N or higher was added to high purity Cu having a purity of 6N and this was used as a raw material, and it was heated and melted to obtain a raw material molten metal. During the heating and melting of the raw material, H₂ gas was continuously blown at a flow rate of 0.3 scfm (8.49 slm) and Ar gas was continuously blown at a flow rate of 10 scfm (283 slm) from a gas blowing nozzle having a circular blowing port shape, in which the diameter thereof is 7 mm, toward a surface of the raw material molten metal upon setting a shortest distance between a tip of the blowing port and the molten metal surface to be 120 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content was 1.5 wtppm and the Ar content was 1 wtppm. Further, in the evaluation test of the discharge stability performed in the same manner as Example 1 regarding this sputtering target, the continuous duration of the plasma was 299 seconds.

### Example 6

1.0 wt% of high purity Al having a purity of 5N or higher was added to high purity Cu having a purity of 6N and this was used as a raw material, and it was heated and melted to obtain a raw material molten metal. During the heating and melting of the raw material, H₂ gas was continuously blown at a flow rate of 0.2 scfm (8.49 slm) and Ar gas was continuously blown at a flow rate of 8 scfm (283 slm) from a gas blowing nozzle having a circular blowing port shape, in which the diameter thereof is 10 mm, toward a surface of the raw material molten metal upon setting a shortest distance between a tip of the blowing port and the molten metal surface to be 130 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content was 1.4 wtppm and the Ar content was 1 wtppm. Further, in the evaluation test of the discharge stability performed in the same manner as Example 1 regarding this sputtering target, the continuous duration of the plasma was 304 seconds.

### Example 7

5.0 wt% of high purity Al having a purity of 5N or higher was added to high purity Cu having a purity of 6N and this was used as a raw material, and it was heated and melted to obtain a raw material molten metal. During the heating and melting of the raw material, H₂ gas was continuously blown at a flow rate of 0.5 scfm (14.15 slm) and Ar gas was continuously blown at a flow rate of 16 scfm (452.8 slm) from a gas blowing nozzle having an oval blowing port shape, in which the major axis thereof is 15 mm and the minor axis thereof is 10 mm, toward a surface of the raw material molten metal upon setting a shortest distance between a tip of the blowing port and the molten metal surface to be 80 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content was 2.1 wtppm and the Ar content was 2 wtppm. Further, in the evaluation test of the discharge stability performed in the same manner as Example 1 regarding this sputtering target, the continuous duration of the plasma was 311 seconds.

### Example 8

3.0 wt% of high purity Al having a purity of 5N or higher was added to high purity Cu having a purity of 6N and this was used as a raw material, and it was heated and melted to obtain a raw material molten metal. During the heating and melting of the raw material, H₂ gas was continuously blown at a flow rate of 0 scfm (0 slm) and Ar gas was continuously blown at a flow rate of 10 scfm (283 slm) from a gas blowing nozzle having an isosceles triangle blowing port shape, in which the base thereof is 15 mm and the height thereof is 10 mm, toward a surface of the raw material molten metal upon setting a shortest distance between a tip of the blowing port and the molten metal surface to be 110 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content was less than 1 wtppm, which is below the detection limit, and the Ar content was 1.3 wtppm. Further, in the evaluation test of the discharge stability performed in the same manner as Example 1 regarding this sputtering target, the continuous duration of the plasma was 305 seconds.

### Example 9

0.5 wt% of high purity Al having a purity of 5N or higher was added to high purity Cu having a purity of 6N and this was used as a raw material, and it was heated and melted to obtain a raw material molten metal. During the heating and melting of the raw material, H₂ gas was continuously blown at a flow rate of 0.4 scfm (11.32 slm) and Ar gas was continuously blown at a flow rate of 0 scfm (0 slm) from a gas blowing nozzle having a quadrangular blowing port shape, in which the long side thereof is 15 mm and the short side thereof is 10 mm, toward a surface of the raw material molten metal upon setting a shortest distance between a tip of the blowing port and the molten metal surface to be 130 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content was 1.3 wtppm and the Ar content was less than 1 wtppm, which is below the detection limit. Further, in the evaluation test of the discharge stability performed in the same manner as Example 1 regarding this sputtering target, the continuous duration of the plasma was 296 seconds.

### Example 10

0.1 wt% of high purity Mn having a purity of 4N or higher was added to high purity Cu having a purity of 6N and this was used as a raw material, and it was heated and melted to obtain a raw material molten metal. During the heating and melting of the raw material, H₂ gas was continuously blown at a flow rate of 0.3 scfm (8.49 slm) and Ar gas was continuously blown at a flow rate of 10 scfm (283 slm) from a gas blowing nozzle having a quadrangular blowing port shape, in which the long side thereof is 15 mm and the short side thereof is 10 mm, toward a surface of the raw material molten metal upon setting a shortest distance between a tip of the blowing port and the molten metal surface to be 90 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content was 1.2 wtppm and the Ar content was 1.4 wtppm. Further, in the evaluation test of the discharge stability performed in the same manner as Example 1 regarding this sputtering target, the continuous duration of the plasma was 334 seconds.

### Example 11

2.0 wt% of high purity Mn having a purity of 4N or higher was added to high purity Cu having a purity of 6N and this was used as a raw material, and it was heated and melted to obtain a raw material molten metal. During the heating and melting of the raw material, H₂ gas was continuously blown at a flow rate of 0.5 scfm (14.15 slm) and Ar gas was continuously blown at a flow rate of 17 scfm (481.1 slm) from a gas blowing nozzle having an isosceles triangle blowing port shape, in which the base thereof is 12 mm and the height thereof is 8 mm, toward a surface of the raw material molten metal upon setting a shortest distance between a tip of the blowing port and the molten metal surface to be 50 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content was 1.8 wtppm and the Ar content was 1.5 wtppm. Further, in the evaluation test of the discharge stability performed in the same manner as Example 1 regarding this sputtering target, the continuous duration of the plasma was 305 seconds.

### Example 12

15 wt% of high purity Mn having a purity of 4N or higher was added to high purity Cu having a purity of 6N and this was used as a raw material, and it was heated and melted to obtain a raw material molten metal. During the heating and melting of the raw material, H₂ gas was continuously blown at a flow rate of 0.4 scfm (11.32 slm) and Ar gas was continuously blown at a flow rate of 15 scfm (424.5 slm) from a gas blowing nozzle having an oval blowing port shape, in which the long side thereof is 20 mm and the short side thereof is 10 mm, toward a surface of the raw material molten metal upon setting a shortest distance between a tip of the blowing port and the molten metal surface to be 100 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content was 1.5 wtppm and the Ar content was 1 wtppm. Further, in the evaluation test of the discharge stability performed in the same manner as Example 1 regarding this sputtering target, the continuous duration of the plasma was 289 seconds.

### Example 13

8.0 wt% of high purity Mn having a purity of 4N or higher was added to high purity Cu having a purity of 6N and this was used as a raw material, and it was heated and melted to obtain a raw material molten metal. During the heating and melting of the raw material, H₂ gas was continuously blown at a flow rate of 0 scfm (0 slm) and Ar gas was continuously blown at a flow rate of 6 scfm (169.8 slm) from a gas blowing nozzle having a square blowing port shape, in which one side thereof is 5 mm, toward a surface of the raw material molten metal upon setting a shortest distance between a tip of the blowing port and the molten metal surface to be 80 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content was less than 1 wtppm, which is below the detection limit, and the Ar content was 1.4 wtppm. Further, in the evaluation test of the discharge stability performed in the same manner as Example 1 regarding this sputtering target, the continuous duration of the plasma was 300 seconds.

### Example 14

1.0 wt% of high purity Mn having a purity of 4N or higher was added to high purity Cu having a purity of 6N and this was used as a raw material, and it was heated and melted to obtain a raw material molten metal. During the heating and melting of the raw material, H₂ gas was continuously blown at a flow rate of 0.3 scfm (8.49 slm) and Ar gas was continuously blown at a flow rate of 0 scfm (0 slm) from a gas blowing nozzle having a circular blowing port shape, in which the diameter is 8 mm, toward a surface of the raw material molten metal upon setting a shortest distance between a tip of the blowing port and the molten metal surface to be 90 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content was 1.2 wtppm and the Ar content was less than 1 wtppm, which is below the detection limit. Further, in the evaluation test of the discharge stability performed in the same manner as Example 1 regarding this sputtering target, the continuous duration of the plasma was 280 seconds.

### Comparative Example 1

High purity Cu having a purity of 6N was used as a raw material, and it was heated and melted to obtain a raw material molten metal. During the heating and melting of the raw material, H₂ gas was continuously blown at a flow rate of 0 scfm (0 slm) and Ar gas was continuously blown at a flow rate of 6 scfm (169.8 slm) from a gas blowing nozzle having a circular blowing port shape, in which the diameter thereof is 5 mm, toward a surface of the raw material molten metal upon setting a shortest distance between a tip of the blowing port and the molten metal surface to be 500 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content and the Ar content were both less than 1 wtppm, which is below the detection limit. Further, in the evaluation test of the discharge stability performed in the same manner as Example 1 regarding this sputtering target, the continuous duration of the plasma was 135 seconds, and considerably shorter in comparison to the respective Examples.

### Comparative Example 2

High purity Cu having a purity of 6N was used as a raw material, and it was heated and melted to obtain a raw material molten metal. During the heating and melting of the raw material, H₂ gas was continuously blown at a flow rate of 0.5 scfm (14.15 slm) and Ar gas was continuously blown at a flow rate of 0 scfm (0 slm) from a gas blowing nozzle having a circular blowing port shape, in which the diameter thereof is 50 mm, toward a surface of the raw material molten metal upon setting a shortest distance between a tip of the blowing port and the molten metal surface to be 200 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content and the Ar content were both less than 1 wtppm, which is below the detection limit. Further, in the evaluation test of the discharge stability performed in the same manner as Example 1 regarding this sputtering target, the continuous duration of the plasma was 125 seconds, and considerably shorter in comparison to the respective Examples.

### Comparative Example 3

2.0 wt% of high purity Al having a purity of 5N or higher was added to high purity Cu having a purity of 6N and this was used as a raw material, and it was heated and melted to obtain a raw material molten metal. During the heating and melting of the raw material, H₂ gas was continuously blown at a flow rate of 0.3 scfm (8.49 slm) and Ar gas was continuously blown at a flow rate of 10 scfm (283 slm) from a gas blowing nozzle having a circular blowing port shape, in which the diameter thereof is 50 mm, toward a surface of the raw material molten metal upon setting a shortest distance between a tip of the blowing port and the molten metal surface to be 200 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content and the Ar content were both less than 1 wtppm, which is below the detection limit. Further, in the evaluation test of the discharge stability performed in the same manner as Example 1 regarding this sputtering target, the continuous duration of the plasma was only 87 seconds, and considerably shorter in comparison to the respective Examples.

### Comparative Example 4

0.5 wt% of high purity Al having a purity of 5N or higher was added to high purity Cu having a purity of 6N and this was used as a raw material, and it was heated and melted to obtain a raw material molten metal. During the heating and melting of the raw material, H₂ gas was continuously blown at a flow rate of 0 scfm (0 slm) and Ar gas was continuously blown at a flow rate of 6 scfm (169.8 slm) from a gas blowing nozzle having a circular blowing port shape, in which the diameter thereof is 5 mm, toward a surface of the raw material molten metal upon setting a shortest distance between a tip of the blowing port and the molten metal surface to be 500 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content and the Ar content were both less than 1 wtppm, which is below the detection limit. Further, in the evaluation test of the discharge stability performed in the same manner as Example 1 regarding this sputtering target, the continuous duration of the plasma was 122 seconds, and considerably shorter in comparison to the respective Examples.

### Comparative Example 5

0.1 wt% of high purity Mn having a purity of 4N or higher was added to high purity Cu having a purity of 6N and this was used as a raw material, and it was heated and melted to obtain a raw material molten metal. During the heating and melting of the raw material, H2 gas was continuously blown at a flow rate of 0.4 scfm (11.32 slm) and Ar gas was continuously blown at a flow rate of 14 scfm (396.2 slm) from a gas blowing nozzle having a circular blowing port shape, in which the diameter thereof is 50 mm, toward a surface of the raw material molten metal upon setting a shortest distance between a tip of the blowing port and the molten metal surface to be 200 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content and the Ar content were both less than 1 wtppm, which is below the detection limit. Further, in the evaluation test of the discharge stability performed in the same manner as Example 1 regarding this sputtering target, the continuous duration of the plasma was 143 seconds, and is considerably shorter in comparison to the respective Examples.

### Comparative Example 6

1.0 wt% of high purity Mn having a purity of 4N or higher was added to high purity Cu having a purity of 6N and this was used as a raw material, and it was heated and melted to obtain a raw material molten metal. During the heating and melting of the raw material, H₂ gas was continuously blown at a flow rate of 0.1 scfm (2.83 slm) and Ar gas was continuously blown at a flow rate of 4 scfm (113.2 slm) from a gas blowing nozzle having a circular blowing port shape, in which the diameter thereof is 5 mm, toward a surface of the raw material molten metal upon setting a shortest distance between a tip of the blowing port and the molten metal surface to be 500 mm. After the melting process, the molten metal was cooled to obtain a cast ingot. After the cast ingot was taken out, it was processed into a shape having a diameter of 440 mm and a thickness of 12 mm to form a Cu sputtering target. As a result of analyzing the contents of Ar and H in this sputtering target, the H content and the Ar content were both less than 1 wtppm, which is below the detection limit. Further, in the evaluation test of the discharge stability performed in the same manner as Example 1 regarding this sputtering target, the continuous duration of the plasma was only 75 seconds, and considerably shorter in comparison to the respective Examples.

**[Table 1]**

| | Material | Composition | Shape of blowing port | Distance between blowing port and molten metal (mm) | Blowing amount of H (scfm) | Blowing amount of Ar (scfm) | H content in material (wtppm) | Ar content in material (wtppm) | Discharge duration (sec) |
|---|---|---|---|---|---|---|---|---|---|
| Example 1 | Cu | - | Circle (φ5 mm) | 100 | 0.7 | 24 | 2 | 1.5 | 350 |
| Example 2 | Cu | - | Quadrangular (8 mm × 3 mm) | 120 | 0.4 | 14 | 1.2 | 1 | 320 |
| Example 3 | Cu | - | Oval (10 mm × 4 mm) | 90 | 0 | 8 | <1 | 1.2 | 314 |
| Example 4 | Cu | - | Triangle (10 mm × 10 mm) | 110 | 0.5 | 0 | 1.2 | <1 | 307 |
| Example 5 | CuAl | 0.1 wt% Al | Circle (φ7 mm) | 120 | 0.3 | 10 | 1.5 | 1 | 299 |
| Example 6 | CuAl | 1.0 wt% Al | Circle (φ 10 mm) | 130 | 0.2 | 8 | 1.4 | 1 | 304 |
| Example 7 | CuAl | 5.0 wt% Al | Oval (15 mm × 10 mm) | 80 | 0.5 | 16 | 2.1 | 2 | 311 |
| Example 8 | CuAl | 3.0 wt% | Triangle (15 mm × 10 mm) | 110 | 0 | 10 | <1 | 1.3 | 305 |
| Example 9 | CuAl | 0.5 wt% | Quadrangular (15 mm × 10 mm) | 130 | 0.4 | 0 | 1.3 | <1 | 296 |
| Example 10 | CuMn | 0.1 wt% Mn | Quadrangular (15 mm × 10 mm) | 90 | 0.3 | 10 | 1.2 | 1.4 | 334 |
| Example 11 | CuMn | 2.0 wt% Mn | Triangle (12 mm × 8 mm) | 50 | 0.5 | 17 | 1.8 | 1.5 | 305 |
| Example 12 | CuMn | 15 wt% Mn | Oval (20 mm × 10 mm) | 100 | 0.4 | 15 | 1.5 | 1 | 289 |
| Example 13 | CuMn | 8.0 wt% Mn | Square (5 mm × 5 mm) | 80 | 0 | 6 | <1 | 1.4 | 300 |
| Example 14 | CuMn | 1.0 wt% Mn | Circle (φ8 mm) | 90 | 0.3 | 0 | 1.2 | <1 | 280 |
| Comparative Example 1 | Cu | - | Circle (φ5 mm) | 500 | 0 | 6 | <1 | <1 | 135 |
| Comparative Example 2 | Cu | - | Circle (φ50 mm) | 200 | 0.5 | 0 | <1 | <1 | 125 |
| Comparative Example 3 | CuAl | 2.0 wt% Al | Circle (φ50 mm) | 200 | 0.3 | 10 | <1 | <1 | 87 |
| Comparative Example 4 | CuAl | 0.5 wt% Al | Circle (φ5 mm) | 500 | 0 | 6 | <1 | <1 | 122 |
| Comparative Example 5 | CuMn | 0.1 wt% Mn | Circle (φ50 mm) | 200 | 0.4 | 14 | <1 | <1 | 143 |
| Comparative Example 6 | CuMn | 1.0 wt% Mn | Circle (φ5 mm) | 500 | 0.1 | 4 | <1 | <1 | 75 |

### Industrial Applicability

According to the embodiment of the present invention, the discharge can be continuously maintained easily in comparison to conventional sputtering targets even under conditions such as low pressure and low gas flow rate where it is difficult to continuously maintain sputtering discharge. Consequently, the sputtering target of the embodiment of the present invention can be effectively used in the process of forming Cu wires of LSI and the like in which demands for low pressure in the sputtering process are increasing in recent years. Because the freedom in the design of the wire layer composition and process conditions will consequently increase, it could be said that the application potentiality and technical contribution of the embodiment of the present invention in the industrial field of semiconductor device production are extremely high.

## Claims

1. A sputtering target formed from copper or a copper alloy comprising, containing argon and/or hydrogen each in an amount of 1 wtppm or more and 10 wtppm or less.

2. The sputtering target according to claim 1, wherein the sputtering target contains only argon out of argon or hydrogen.

3. The sputtering target according to claim 1 or claim 2, wherein the sputtering target contains only hydrogen out of argon or hydrogen.

4. The sputtering target according to claim 1, wherein the sputtering target contains both argon and hydrogen.

5. The sputtering target according to any one of claims 1 to 4, wherein the sputtering target is formed from a copper alloy containing either aluminum or manganese.

6. The sputtering target according to any one of claims 1 to 5, wherein the copper alloy is a copper alloy which contains 0.1 to 5 wt% of aluminum, or 0.1 to 15 wt% of manganese.

7. A method of producing the sputtering target according to any one of claims 1 to 6, the method comprising:
preparing a copper or copper alloy raw material;
melting the prepared raw material in an atmosphere into which argon and/or hydrogen was introduced;
cooling and solidifying the melted raw material into a copper or copper alloy ingot; and
processing the ingot into a sputtering target.
